Europäisches Patentamt

European Patent Office

Office européen des brevets

(19)

(11) Numéro de publication: **0 062 568
B1**

(12)

# FASCICULE DE BREVET EUROPEEN

(45) Date de publication du fascicule du brevet:
**27.11.85**

(21) Numéro de dépôt: **82400539.1**

(22). Date de dépôt: **25.03.82**

(51) Int. Cl.⁴: **H 03 K 17/955, B 60 J 1/17,
E 05 F 15/00, H 02 P 7/00**

(54) Sécurité électronique sur le moteur d'une fenêtre coulissante.

(30) Priorité: **25.03.81 DE 3111684**

(43) Date de publication de la demande:
**13.10.82 Bulletin 82/41**

(45) Mention de la délivrance du brevet:
**27.11.85 Bulletin 85/48**

(84) Etats contractants désignés:
**BE DE FR GB IT SE**

(56) Documents cités:
**DE - A - 2 917 454
US - A - 3 651 389
US - A - 3 725 748
US - A - 3 868 626**

**Le dossier contient des informations techniques
présentées postérieurement au dépôt de la demande et
ne figurant pas dans le présent fascicule.**

(73) Titulaire: **SAINT-GOBAIN VITRAGE, Les
Miroirs 18, avenue d'Alsace, F-92400 Courbevole (FR)**

(84) Etats contractants désignés: **BE FR GB IT SE**

(73) Titulaire: **VEGLA Vereinigte Glaswerke GmbH, Viktoria
Allee 3-5, D-5100 Aachen (DE)**

(84) Etats contractants désignés: **DE**

(72) Inventeur: **Sauer, Gerd, Heinrich Hamacher Weg 11,
D-5120 Stolberg-Venwegen (DE)**
Inventeur: **Unbehaun, Dieter, Kobergerstrasse 58,
D-8500 Nuernberg (DE)**

(74) Mandataire: **Breton, Jean-Claude et al, SAINT-GOBAIN
RECHERCHE 39, quai Lucien Lefranc,
F-93300 Aubervilliers Cedex (FR)**

## Description

L'invention a pour objet un circuit de commande électronique servant de sécurité sur le moteur d'entraînement d'une fenêtre coulissante, en particulier une fenêtre d'automobile dont la vitre porte le long de son bord libre un conducteur électrique qui constitue le capteur capacitif d'un étage de détection à oscillateur appartenant au circuit de commande, ces organes fournissant à un amplificateur qui coupe l'alimentation du moteur d'entraînement un signal proportionnel à l'altération créée quand une partie du corps vient à proximité immédiate du capteur. Un circuit de commande de ce type est connu par le brevet US 3 651 389.

Pour travailler de façon entièrement efficace, un tel circuit doit interrompre le mouvement de fermeture de la fenêtre non seulement quand le capteur se trouve en contact conducteur direct mais aussi en cas de simple proximité immédiate avec une partie du corps, par exemple lorsque cette partie du corps est couverte par une pièce de vêtement. Le détecteur doit donc répondre à une influence capacitive, voie qui exige, pour obtenir la coupure à coup sûr, une sensibilité relativement élevée. Ceci crée un risque que le circuit de commande réagisse aussi à certaines influences parasites, c'est-à-dire à des altérations du signal de l'oscillateur qui auraient une cause autre que l'approche du capteur par une partie du corps.

De telles altérations se produisent, par exemple, lorsqu'apparaît sur la vitre un dépôt d'humidité, que ce soit sous forme de buée, sous forme d'un film d'eau ou même sous forme d'un dépôt salé. Il s'en produit également lorsque le capteur approche du cadre de la fenêtre ou en cas de perturbation du circuit, notamment par pénétration d'eau dans le caisson de la portière, modification des positions respectives des divers éléments du circuit lors du déplacement de la vitre ou sous l'influence de variations importantes de la température.

Un autre type de circuit de commande comportant un capteur capacitif est connu par le brevet US 3 725 748. Ce circuit utilise uniquement la capacité du capteur. Il sépare les signaux utiles des signaux parasites en détectant l'importance de la variation de la capacité par unité de temps de façon telle qu'un relais de puissance ne soit commandé que par des variations rapides, telles que celles provoquées par l'approche du capteur d'une partie du corps.

Les variations de la capacité sont, dans les conditions normales d'un vitrage automobile, extrémement faibles. En outre la capacité du capteur dans les cas d'un vitrage humide devient négligeable et presque impossible à mesurer. Par conséquent l'application de ce circuit connu pour la commande d'un vitrage automobile ne peut pas résoudre les problèmes surgissant dans ce cas particulier.

L'invention a pour objet un circuit apte à la commande du moteur d'entraînement d'une fenêtre coulissante d'une automobile, circuit qui est susceptible d'identifier les signaux parasites, c'est-à-dire ceux qui ont une autre cause que l'approche du capteur par une partie du corps, de sorte que le blocage du moteur provienne â coup sûr d'une telle approche.

Selon l'invention, l'étage de détection comprend un circuit d'évaluation qui évalue l'importance de la variation par unité de temps de la résistance parallèle de fuite du capteur capacitif et sépare les signaux utiles des signaux parasites dont le taux de variation est inférieur à 10% par seconde et de préférence inférieur à 5% par seconde afin de neutraliser des derniers.

L'invention tire profit de la découverte que, dans les conditions des fenêtres coulissantes d'une automobile, la variation de la résistance parallèle de fuite du capteur capacitif est nettement plus importante que la variation de la capacité même et elle propose donc d'utiliser cette variation de la résistance parallèle du capteur pour la commande du moteur d'entraînement. L'invention utilise, d'autre part, le fait que, normalement, les variations du signal dues à l'humidification de la vitre sont de l'ordre de 1% par seconde, alors qu'elles dépassent normalement 10% lorsqu'on pose la main sur le vitrage. Un taux de variation du signal de 5% par seconde s'est révélé un critère sûr pour distinguer les signaux utiles des signaux parasites.

Le mode opératoire de l'organe selon l'invention à l'intérieur de l'étage de détection est d'en modifier la sensibilité lorsqu'apparaît un signal et de vérifier ensuite si la relation entre le signal détecté alors, c'est-à-dire après un certain intervalle de temps et le signal initial correspond aux caractéristiques d'un signal utile. Ce principe peut être mis en œuvre de façons diverses.

Selon un premier mode opératoire, le circuit de commande renfermant un comparateur de tensions qui définit le seuil de commande, l'organe transcripteur comprend une chaîne de résistances qui, introduites dans le circuit ou soustraites l'une après l'autre de celui-ci par un commutateur, en modifient par étapes la sensibilité, et un relais temporisé qui, un intervalle de temps donné après chaque enclenchement, vérifie l'état de sortie du comparateur et déconnecte de proche en proche les résistances successives tant que cet état ne s'est pas à nouveau modifié.

Dans cette mise en œuvre, l'étage de détection travaille d'abord au gain le plus faible. Si maintenant le capteur crée un amortissement suffisant pour que le signal atteigne le seuil pendant que la vitre se ferme, le circuit arrête le moteur et commute en même temps le gain supérieur. Il vérifie alors, après un intervalle de temps donné, de 0,1 à 0,5 seconde par exemple, si l'amortissement possède une valeur correspondant à la nouvelle sensibilité: si le seuil n'est plus atteint, c'est que la pente du signal est moins raide que celle d'un signal utile; le comparateur retombe donc et le moteur d'entraînement est remis en circuit dans la mesure où le contacteur reste pressé. Après un intervalle de temps plus long, de 3 secondes par exemple, les résistances sont réintroduites pour restaurer la sensibilité initiale. Si, au contraire, le seuil est encore franchi sous la nouvelle sensibilité, cela signifie que le signal présente une pente supérieure à celle choisie pour la détection, et le moteur d'entraînement reste coupé. De façon avantageuse, l'augmentation de gain se produit en plusieurs étapes; ceci permet de neutraliser par degrés l'amortissement par le capteur à l'approche du cadre tout en conservant une sensibilité suffisante à l'égard de fluctuations créées par l'approche ou la simple présente d'une partie du corps. Sur un tel circuit, la fenêtre, en fin de parcours, se ferme pas à pas et c'est un contact de fin de course qui la stoppe entièrement lorsqu'elle atteint sa pleine position de fermeture.

Une autre mise en œuvre avantageuse se caractérise par le fait que l'étage de détection possède un amplificateur à contre-réaction, en particulier muni d'un transistor à effet de champ dont la résistance drain/source diminue continûment lorsque l'amortissement créé par le capteur augmente et qui égalise ainsi la tension de sortie de cet amplificateur, si bien que la tension de détection qui fixe le seuil diminue continûment, le choix de la constante de temps vis-à-vis de l'augmentation d'amortissement faisant que ce seuil ne sera atteint par le signal que si l'on dépasse la vitesse déterminée de modification de l'amortissement.

D'autre part, le temps de désensibilisation avant remise à zéro du circuit, c'est-à-dire le laps de temps qui s'écoule, après une perturbation du circuit, jusqu'à ce que sa sensibilité initiale soit restaurée doit être aussi court que possible. On obtient un temps de désensibilisation correct quand la constante de temps du circuit, à cet égard, possède une valeur de 10% de celle qu'il présente vis-à-vis de l'attaque du signal, c'est-à-dire de l'augmentation de l'amortissement: pour ce qui est du retour à zéro du seuil de commande après suspension du signal, cette forme de circuit sera capable de suivre les décroissances de l'amortissement tant qu'elles ne dépasseront pas 50% par seconde et si possible 100% par seconde.

Un troisième mode de construction possible selon l'invention se caractérise par le fait que l'étage de détection comprend un oscillateur à fréquence variable en fonction de l'altération de la résistance parallèle de fuite du détecteur, un compteur mesureur de fréquence et un circuit d'évaluation pilotant le relais coupant l'alimentation du moteur d'entraînement. Un tel circuit travaille numériquement, ce qui lui confère quelques caractéristiques que les autres circuits décrits ne permettent pas d'atteindre.

L'invention sera définie ci-dessous de façon plus détaillée et divers exemples de mise en œuvre de correction automatique du seuil conformes à l'invention seront décrits en liaison avec les dessins. Ces dessins montrent:

– fig. 1: le schéma d'un vitrage coulissant destiné à une fenêtre d'automobile, équipé d'une bande électriquement conductrice servant de capteur au détecteur de proximité;

– fig. 2: le schéma du circuit équivalent au capteur;

– fig. 3: un diagramme montrant, dans diverses conditions, l'évolution de la résistance de fuite en fonction de la position de la vitre dans l'ouverture de la fenêtre;

– fig. 4: un schéma d'un circuit de commande de moteur de fenêtre dont la sensibilité varie par degrés;

– fig. 5: un schéma d'un circuit de commande de moteur à variation continue du seuil;

– fig. 6: un schéma par blocs d'un circuit de commande du moteur possédant un transcripteur numérique;

– fig. 7: la construction de l'oscillateur à fréquence variables du circuit de commande représenté par la figure 6;

– fig. 8: la construction de l'étage final du circuit de commande de la figure 6;

– fig. 9: une vitre porteuse de lignes de commutation auxiliaires permettant d'ouvrir ou de fermer le circuit ou d'en modifier la sensibilité dans des positions données;

– fig. 10: un schéma d'un circuit de commande à variation auxiliaire de la sensibilité selon la position de la vitre.

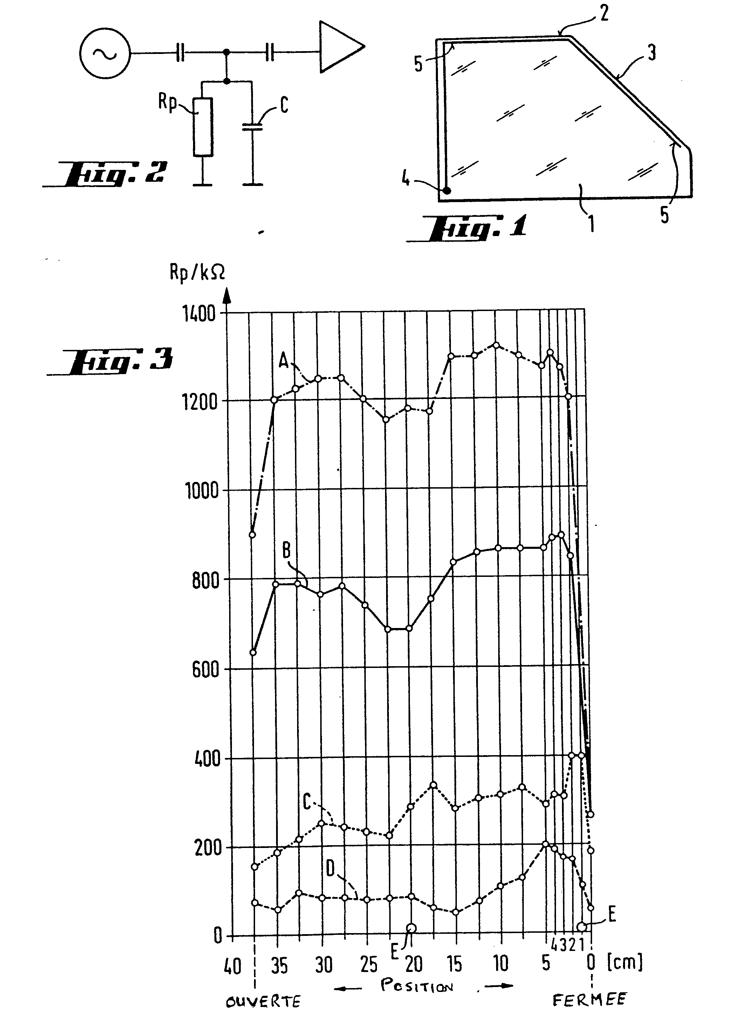

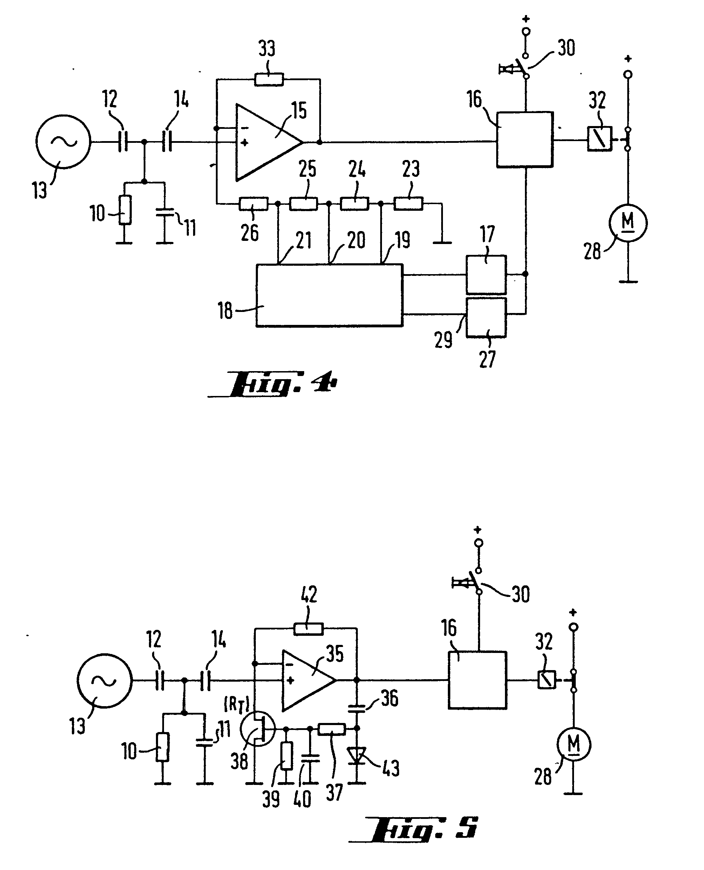

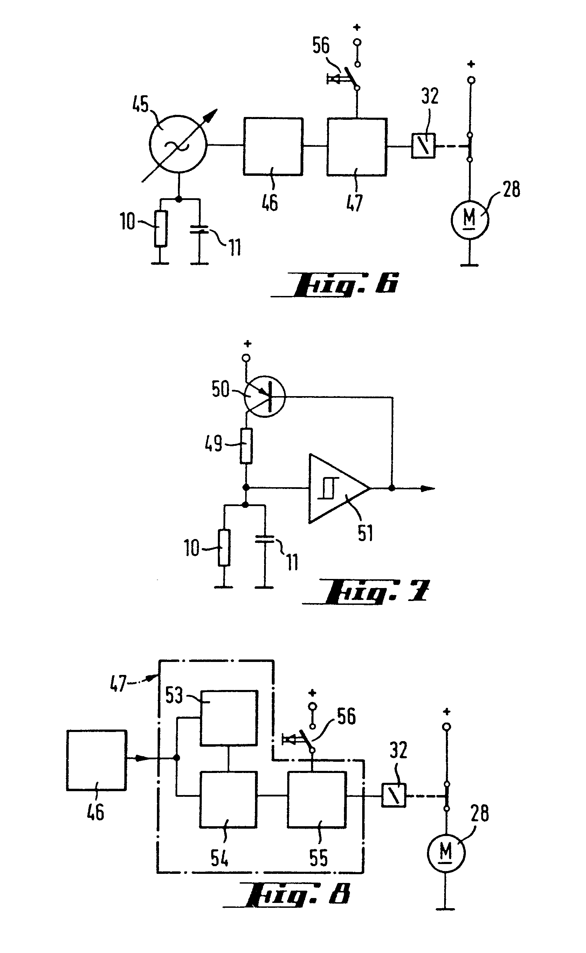

La figure 1 représente schématiquement une vitre 1 destinée à équiper la porte d'un véhicule automobile. Un élément important du circuit de sécurité appartenant à la commande du moteur d'entraînement de la vitre 1 est constitué par un capteur disposé sur cette vitre le long du bord supérieur 2 et du bord avant oblique 3, sous forme d'une ligne électroconductrice 5 alimentée à partir d'un point 4 et qui réagit aux influences capacitives de façon à répondre au contact d'une partie du corps, par exemple une main gantée.

Comme le montre la figure 2, l'étage de détection associe un oscillateur au capteur dont on surveille les caractéristiques électriques. Ce capteur peut être représenté par un schéma équivalent sous forme d'un condensateur de capacité $C$ associée en parallèle à une résistance de fuite $R_p$. Les grandeurs $C$ et $R_p$ dépendent de facteurs divers comme la longueur de la ligne, la taille du vitrage, la construction du cadre, l'humidité de la vitre ... Elles varient aussi en fonction de la position de la vitre à l'intérieur de l'ouverture de la fenêtre et changent enfin quand une partie du corps vient à proximité immédiate du détecteur, la variation de $R_p$ étant prédominante.

Dans le diagramme montré par la figure 3 apparaît la variation de la résistance de fuite $R_p$ dans diverses circonstances, valeur mesurée sur la vitre avant gauche, du côté du conducteur, d'une automobile du type Mercedes W 123, pour une fréquence d'oscillation de 250 kHz; la longueur du capteur sur le vitrage était de 95 cm.

La courbe A montre la variation de la résistance de fuite de $R_p$ sur une vitre sèche, en fonction de sa position. Lorsque la fenêtre est entièrement ouverte, $R_p$ a une valeur de l'ordre de 900 kΩ; elle monte jusqu'à une valeur de 1300 kΩ au fur et à mesure qu'on lève la vitre, pour retomber brutalement jusqu'à environ 200 kΩ lorsque le détecteur approche de la partie supérieure du cadre.

La courbe B montre la façon dont $R_p$ se modifie par contact de la main sur le bord supérieur, dans chacune des positions d'une telle vitre sèche. On voit que, dans la zone d'ouverture intéressante, la valeur de $R_p$ est plus basse d'environ 400 kΩ lorsque le circuit est amorti par la main que sur le vitrage non amorti que caractérisait la courbe A. Pour que l'influence du contact fût régulière, l'expérience fut effectuée en posant sur le bord supérieur de la vitre une main artificielle de caractéristiques électriques constantes.

La courbe C montre les caractéristiques de résistance de fuite $R_p$ du même vitrage à l'état humide, c'est-à-dire dans l'état créé par un fort dépôt de buée sur la face interne de la vitre ou encore en cas de bruine ou au début d'une averse. On voit sur le diagramme que la valeur de $R_p$ est fortement influencée par l'humidité.

Une chute encore plus considérable de la résistance de fuite se produit par forte pluie lorsque le vitrage est très humide. Les résistances $R_p$ mesurées dans ce cas correspondent à la courbe D, qui montre que, même dans ce cas extrême, la résistance atteint encore en moyenne une centaine de milliers d'ohms.

Si maintenant on touche le bord supérieur d'une fenêtre mouillée, la résistance de fuite tombe pratiquement à zéro comme le montrent les points de mesure E.

Pour résoudre le problème créé par le fait que des influences perturbatrices telles qu'un dépôt d'humidité sur le vitrage sont susceptibles de modifier le fonctionnement de l'étage de détection chargé par le capteur, l'invention n'utilisera pas pour commander l'étage de commande la valeur absolue du signal mais sa vitesse de variation. On peut, en effet, remarquer que les altérations suscitées par des influences perturbatrices telles que l'humidité interviennent assez lentement et ne dépassent normalement pas une valeur de l'ordre de 1% par seconde.

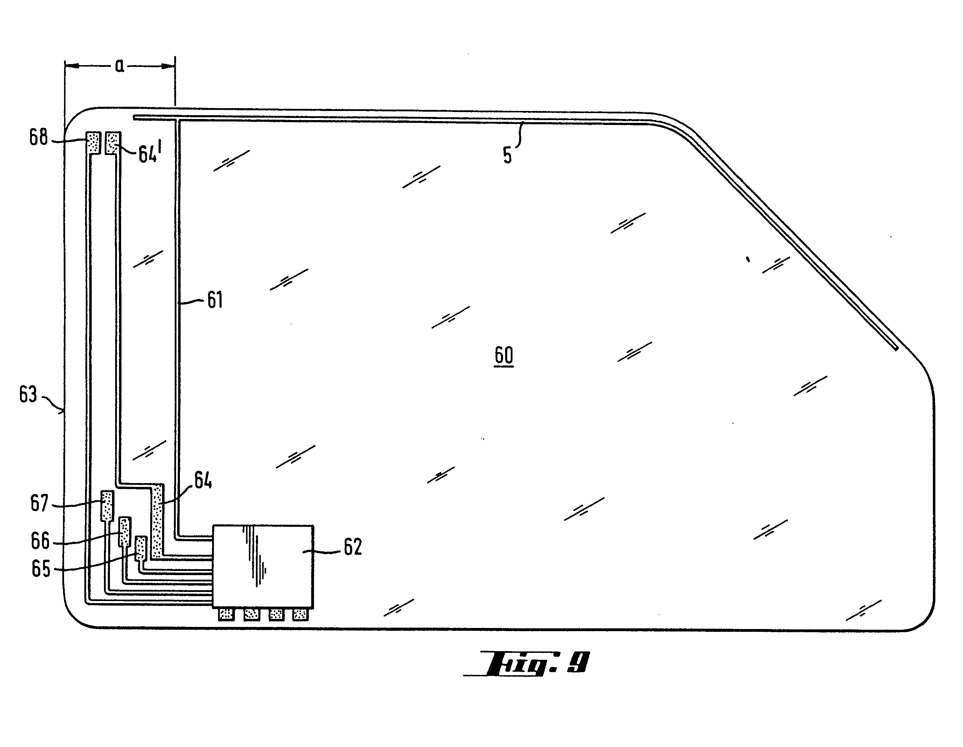

La figure 4 montre le principe de construction d'un circuit de commande à seuil de sortie fixe dont le gain augmente par degrés par suppression progressive de résistances lorsqu'on dépasse le seuil de commande. Le capteur, représenté sous la forme du schéma équivalent comprenant la résistance de fuite 10 et la capacité 11 est relié par un condensateur de couplage 12 à l'oscillateur 13. L'oscillateur travaille à une fréquence de 250 kHz. La tension qu'il fournit dépend de l'importance de l'amortissement et elle est transmise par un condensateur de couplage 14 à un amplificateur 15.

A la sortie de l'amplificateur 15, l'étage de commande 16 alimente un relais à temps 17 monté à l'entrée d'un compteur 18 dont les sorties 19 à 21 sont branchées en dérivation entre les résistances potentiométriques 23 à 26 d'une boucle de contre-réaction alimentant la borne – de l'amplificateur. Si ce dernier reçoit sur sa borne + un signal assez atténué pour enclencher le fonctionnement de l'étage de commande 16, le moteur s'arrête mais en outre, si le signal affaibli se prolonge un certain temps, au moins 0,5 seconde par exemple, le gain va augmenter. En effet, 0,5 seconde après l'enclenchement de l'étage de commande 16, le relais 17 fait progresser d'une position le compteur 18 qui court-circuite ainsi, sur sa sortie 19, la résistance 23, de sorte que le gain de l'amplificateur 15 passe au degré supérieur. Si l'atténuation du signal est suffisante pour que, dans ces conditions, l'étage de commande 16 reste encore 0,5 seconde sans modification d'état, c'est la sortie 20 du compteur 18 qui est mise à la masse à son tour, ce qui court-circuite la résistance 24, puis ce sera la sortie 21 donc la résistance 25. Le compteur 18 s'arrête aussitôt que, le signal s'étant stabilisé, l'étage de commande 16 revient à son état initial.

Le relais à temps 27 se trouve alors excité et au bout de 3 secondes, sa sortie 29 fournit au compteur 18 une impulsion de remise à zéro qui réintroduit dans le circuit les résistances 23 à 25 de sorte que l'amplificateur 15 retrouve sa sensibilité initiale. Le moteur d'entraînement 28 de la vitre ne redémarre toutefois que lorsque l'étage de commande 16 pilotant le relais de puissance 32 reçoit sous l'effet du contacteur 30 une impulsion de démarrage renouvelée.

Les caractéristiques du circuit sont les suivantes:

| | |
|---|---|
| – condensateur 12 | 30 pF |
| – condensateur 14 | 30 pF |
| – résistance 33 | 1 MΩ |
| – résistance 26 | 1 kΩ |
| – résistance 25 | 50 Ω |
| – résistance 24 | 50 Ω |
| – résistance 23 | 50 Ω |
| – amplificateur 15 | type 741 |
| – compteur 18 | type 7490 oK |
| – retardateur 17 | type 555 |
| – retardateur 27 | type 555 |

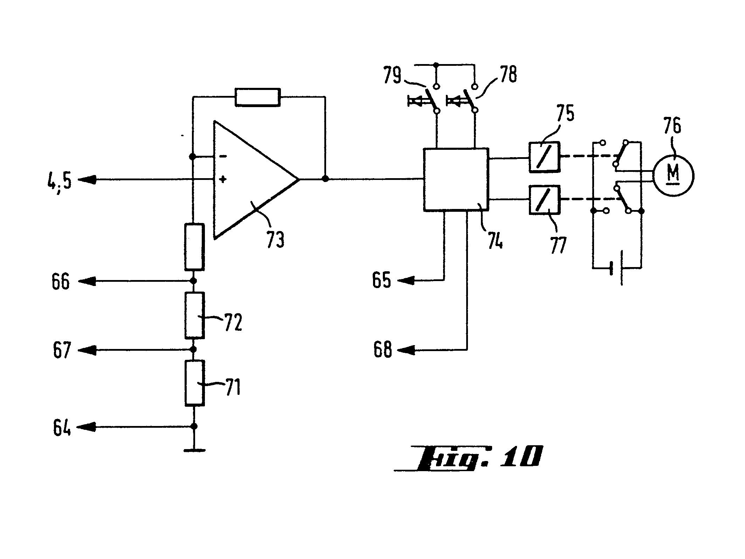

Dans le circuit représenté par la figure 5, le degré d'amortissement provoqué par le capteur, équivalent à l'ensemble de la résistance 10 et de la capacité 11 et qui est relié par le condensateur de couplage 12 à l'oscillateur 13 modifie à nouveau, comme dans le cas du schéma de la figure 4, la tension délivrée à travers le condensateur de couplage 14 mais, lorsque l'amortissement créé par le capteur augmente, c'est-à-dire lorsque la tension du signal sur le condensateur 14 diminue, l'amplificateur 35 abaisse parallèlement le seuil de détection de façon continue. Dans ce but, la tension de sortie sous laquelle il alimente l'étage de commande 16 est transmise à travers le condensateur 36 et la résistance 37 au transistor à effet de champ 38 qui relie à la masse sa borne –. La résistance drain-source $R_t$ du transistor 38 diminue ainsi avec la tension de sortie de l'amplificateur 35, augmentant de façon continue le gain de ce dernier, ce qui l'asservit dans le sens désiré.

La constante de temps de ce réglage d'augmentation du gain pour permettre de distinguer d'un signal parasite un signal utile provoqué par un contact est déterminée par la résistance 39 et le condensateur 40. C'est une variation de l'amortissement de l'ordre de 5% par seconde qui s'est montrée utile pour distinguer sûrement ces signaux. Il convient alors de donner à la résistance 39 une valeur de 1 MΩ et au condensateur 40 une valeur de 10 μF.

La constante de temps de redescente de l'ajustement de l'amplificateur, c'est-à-dire l'intervalle de temps qui s'écoule après un signal utile jusqu'à ce que l'amplificateur retrouve sa sensibilité initiale doit être aussi courte que possible de façon que le circuit ne «s'habitue» pas au contact. Des essais ont montré qu'elle était avantageusement de l'ordre de 10% de celle de l'ajustement du réglage de sensibilité.

Les autres éléments du circuit peuvent avoir les valeurs suivantes:

| | |
|---|---|
| – condensateur 12 | 10 pF |
| – condensateur 14 | 10 pF |
| – condensateur 36 | 100 nF |
| – résistance 37 | 100 kΩ |
| – résistance 42 | 1 MΩ |
| – diode lisseuse 43 | type 1 N 4148 |
| – amplificateur 45 | type 741 |
| – transistor à effet de champ 38 | type BF 245 |

Les figures 6 à 8 représentent dans son principe une forme de circuit de commande utilisant un traitement numérique du signal. Le capteur, dont le schéma figure à nouveau la résistance de fuite 10 et la capacité 11 agit dans ce cas sur un oscillateur 45 à fréquence variable. La fréquence de l'oscillateur 45 est mesurée dans un compteur 46 et restituée sous forme binaire à un transcripteur 47 pilotant le relais 32 qui commande le moteur 28 d'entraînement de la fenêtre.

La construction de l'oscillateur à fréquence variable 45 est représentée, à titre d'exemple, sur la figure 7. Il comprend le capteur, équivalent à la résistance parallèle de fuite 10 et à la capacité 11, une résistance de charge 49, un transistor 50 et un comparateur de tensions à hystérésis 51. Lors de la mise en route, le transistor 50 est rendu conducteur car la sortie du comparateur 51 se trouve à potentiel nul; la capacité 11 se charge à travers la résistance 49. Lorsque le seuil de commutation est atteint sur la borne + du comparateur 51, la sortie de ce comparateur prend l'état 1, ce qui bloque le transistor 50; la capacité 11, n'étant plus alimentée, se décharge progressivement à travers la résistance 10 jusqu'à ce que le seuil de tension inférieur du comparateur 51 soit atteint. Un nouveau cycle de chargement de cette capacité commence alors. Comme un contact sur le capteur abaisse la valeur de la resistance parallèle 10, la durée de chargement et de déchargement se réduit, ce qui élève la fréquence de la tension rectangulaire obtenue à la sortie du comparateur de tension 51.

Le transcripteur 47 comprend, comme la figure 8 le montre en détail, un registre à mémoire 53 et un soustracteur 54 attaquant l'étage de commande 55. La première valeur fournie par le compteur 46 atteint à la fois le soustracteur 54 et le registre 53 où elle est mise en mémoire. Lorsque la suivante atteint le compteur 53, elle y est mise en mémoire à son tour et, dans le soustracteur 54 elle est soustraite de la précédente. Le résultat de la soustraction donne la variation de fréquence de l'oscillateur, qui sert de grandeur de détection. Si ce résultat est nul, c'est qu'il n'y a pas de variation du fonctionnement; s'il est négatif c'est que la fréquence augmente, sa vitesse de variation se déduisant de sa valeur à travers la durée de l'opération. Au-delà d'un certain seuil qui correspond à une altération de l'ordre de 5% par seconde, l'étage de commande 55 s'enclenche, ce qui excite le relais de puissance 32, coupant l'alimentation du moteur 28. Ce dernier se remet en marche aussitôt que l'étage de commande 55 reçoit sur le contacteur 56 une nouvelle impulsion de démarrage.

Le transcripteur 47 constitue un circuit logique séquentiel qui, même dans le cas le plus simple est déjà relativement complexe. Il est donc indiquée de lui donner la forme d'un microprocesseur effectuant à la fois le comptage et le processus logique de commande ce qui élargit notablement les possibilités de détection: c'est ainsi que l'on peut, par exemple, prendre en compte dans la mesure, la valeur statique du signal pour modifier le calcul, dans ces conditions, il est en particulier intéressant de faire varier le seuil de détection de la variation du signal en fonction de la valeur absolue de celui-ci, pour engendrer une plage de détection ou une fonction caractéristique à partir de laquelle s'effectue la commande.

Tous les circuits décrits peuvent être complétés par des lignes et éléments de commutation secondaires permettant de modifier la sensibilité de l'amplificateur en fonction de la position de la vitre dans l'ouverture de la fenêtre. Les lignes de commutation nécessaires à cette fin peuvent être disposées sur la vitre, dans sa zone latérale, leurs plages de contact coopérant avec des contacts glissants disposés dans le cadre de la fenêtre. De tels éléments auxiliaires peuvent être utiles pour pallier la chute brutale de la résistance de fuite du détecteur à l'approche du bord supérieur du cadre, en modifiant le branchement en conséquence.

Une forme possible d'éxécution d'une vitre 60 équipée de telles lignes de commutation auxiliaires est montrée figure 9. La ligne de liaison 61 entre le capteur 4 proprement dit et les organes de détection, représentés ici sous forme d'un circuit intégré 62 fixé directement sur la vitre 60, se trouve à une distance a du bord verticale 63 de cette vitre. Dans la marge comprise entre ce bord vertical et la ligne de liaison 61 sont placées cinq bandes conductrices, toutes raccordées au circuit de commande 62; aux emplacements où elles doivent être reliées entre elles par l'intermédiaire d'un contact glissant disposé dans le cadre de la fenêtre sont placées des plages de contact élargies 64, 64', 65, 66, 67 et 68. Les lignes conductrices sont revêtues d'une couche isolante qui ne laisse à nu que ces plages de contact.

Dans le cas représenté, les deux plages de contact 64 et 67 sont reliées par le contact glissant peu avant la fermeture de la fenêtre, dans une position telle que le bord supérieur de la vitre se trouve à une distance de l'ordre de 3 cm du cadre. Comme le montre schématiquement la figure 10, la résistance 71 se trouve ainsi courtcircuitée, ce qui augmente le gain de l'amplificateur 73 et compense la chute de la résistance de fuite $R_p$ provoquée par le fait que le capteur s'approche du cadre de la fenêtre; tandis que le seuil de détection s'abaisse, la vitre poursuit son mouvement de fermeture. Cette compensation de la chute de la résistance de fuite par élévation du gain s'effectue par degrés; précisément, l'orsque la plage de contact 66 atteint le contact glissant, la résistance 72 est court-circuitée à son tour et l'étage de détection commuté sur la plage de gain supérieure.

Quand la vitre parvient à sa position de fermeture complète, c'est la plage de contact 65 qui atteint le contact glissant. Elle agit directement sur l'étage de commande 74 pour couper, par l'intermédiaire du relais 75, l'alimentation du moteur 76. La plage de contact 68, elle aussi, agit directement sur l'étage de commande 74; elle sert à arrêter le moteur par l'intermédiaire du relais 77 dans la position d'ouverture complète. Le contacteur manuel 78 qui commande la descente agit directement sur l'étage de commande 74, l'étage de détection étant alors mis hors service. Le contacteur manuel 79 sert à faire monter la vitre, ce qui remet en même temps l'étage de détection en service.

**Revendications**

1. Circuit de commande électronique servant de sécurité sur le moteur d'entrainement d'une fenêtre coulissante, en particulier d'une fenêtre d'automobile, dont la vitre porte, le long de son bord libre, un conducteur électrique qui constitue le capteur capacitif d'un étage de détection à oscillateur appartenant au circuit de commande, ces organes fournissant à un amplificateur qui coupe l'alimentation du moteur d'entrainement un signal proportionnel à l'altération créée quand une partie du corps vient à proximité immédiate du capteur, caractérisé en ce que l'étage de détection comprend un circuit d'évaluation qui évalue l'importance de la variation par unité de temps de la résistance parallèle de fuite du capteur capacitif et sépare les signaux utiles des signaux parasites dont le taux de variation est inférieur à 10% par seconde et de préférene inférieur à 5% par seconde afin de neutraliser ces derniers.

2. Circuit de commande selon la revendication 1, caractérisé en ce que l'oscillateur de l'étage de détection travaille à une fréquence de 250 kHz.

3. Circuit de commande selon la revendication 1 ou 2, renfermant un comparateur de tension définissant le seuil de commande, et caractérisé en ce que le circuit d'évaluation comprend une chaine de résistances (23, 24, 25) qui, introduites dans le circuit ou soustraites l'une après l'autre de celui-ci par un commutateur (18), en modifient par étapes la sensibilité et un relais temporisé (17) qui, un intervalle de temps donné après chaque enclenchement vérifie l'état de sortie du comparateur (16) et déconnecte de proche en proche les résistances successives tant que cet état ne s'est pas à nouveau modifié.

4. Circuit de commande selon la revendication 3, caractérisé en ce que le relais temporisé (17) est construit de façon que les ajustements successifs de sensibilité à la décroissance du signal interviennent à des intervalles de 0,1 à 0,5 s.

5. Circuit de commande selon l'une des revendications 3 et 4, caractérisé en ce que le circuit d'évaluation comprend un deuxième relais temporisé (27) par l'intermédiaire duquel, au bout d'un intervalle de temps supplémentaire de 1 à 3 s à partir de la remise en circuit du moteur d'entraînement (28), les résistances (23, 24, 25) sont à nouveau connectées pour restituer la sensibilité initiale.

6. Circuit de commande selon la revendication 1 ou 2, caractérisé en ce que le circuit d'évaluation comprend un amplificateur à contre-réaction muni d'un transistor à effet de champ dont la résistance drain/source diminue continûment lorsque l'amortissement créé par le capteur augmente et qui égalise ainsi la tension de sortie de cet amplificateur, le choix de la constante de temps vis-à-vis de l'augmentation d'amortissement faisant que ce seuil ne sera atteint par le signal que si l'on dépasse une vitesse déterminée de modification de l'amortissement.

7. Circuit de commande selon la revendication 6, caractérisé en ce que la constante de temps du circuit d'évaluation renfermant le transistor à effet de champ (38), déterminée par un premier groupe RC (39, 40) est choisie de manière à suivre les augmentations d'amortissement aussi longtemps qu'elles sont inférieures à 10% par seconde.

8. Circuit de commande selon l'une des revendications 6 et 7, caractérisé en ce que le circuit d'évaluation renfermant le transistor à effet de champ (38) possède sur la base de ce transistor un deuxième groupe RC (36, 37) conférant à la désensibilisation de l'amplificateur (35) une constante de temps qui permet d'effacer les diminutions d'amortissement jusqu'à 50% par seconde et de préférence jusqu'à 100% par seconde.

9. Circuit de commande selon la revendication 1 ou 2, caractérisé en ce que le circuit d'évaluation comprend un oscillateur à frequence variable (45) en fonction de l'altération de la resistance parallèle de fuite du capteur (4), un compteur mesureur (46) de frequence, et un circuit d'évaluation (47) pilotant le relais (32) coupant l'alimentation du moteur d'entrainement (28).

10. Circuit de commande selon revendication 9, caractérisé en ce que l'oscillateur à fréquence variable (45) comprend un transistor (50) et un comparateur de tension à hystérésis (51).

11. Circuit de commande selon revendication 9 et 10, carctérisé en ce que le circuit d'évaluation (47) comprend un registre à mémoire (53), un soustracteur (54) et un étage de commande (55), le resultat de la soustraction dans le soustracteur (54) servant de grandeur de la variation de la resistance parallèle de fuite du capteur capacitif.

12. Circuit de commande selon l'une des revendications 1 à 11, caractérisé qu'il comprend des éléments de commutation secondaires (résistances 71, 72) commandés par des lignes de commutation disposées sur le vitrage (60) de façon à coopérer avec un contact glissant placé dans le cadre de la fenêtre pour augmenter par degrés le gain de l'amplificateur en fonction de la position de la fenêtre dans la phase finale de fermeture de cette dernière, et un contact (65) disposé sur ledit vitrage de manière à coopérer avec ledit contact glissant pour couper l'alimentation du moteur, lorsque la vitre est fermée.

## Claims

1. An electronic control safety circuit for a motor for driving a sliding window, such as a window of an automobile, of which the pane carries along its free edge an electrical conductor which forms the capacitative detector of an oscillator detection stage of the control circuit, these members feeding a signal proportional to the alteration created when a part of the body comes into the immediate proximity of the detector to an amplifier which disconnects feed of current to the driving motor, characterised in that the detection stage comprises a measuring circuit which measures the magnitude of the variation per unit time of the parallel leak resistance of the capacitative detector and separates the useful signals from parasite signals of which the variation is less then 10% per second and preferably less than 5% per second in order to neutralise the latter signals.

2. Control circuit according to claim 1, characterised in that the oscillator of the detection stage operates at a frequency of 250 kHz.

3. Control circuit according to claim 1 or 2, containing a voltage comparator defining the control threshold, and characterised in that the measuring circuit comprises a series of resistances (23, 24, 25) which, introduced into or withdrawn from the circuit one after another by a commutator (18), modify the sensitivity in stages and a delay relay (17) which, at a given interval of time after each engagement, verifies the output state of the comparator (16) and disconnects the successive resistances one after another while this state has not again been modified.

4. Control circuit according to claim 3, characterised in that the delay relay (17) is such that successive adjustments of sensitivity to decrease of the signal take place at intervals from 0.1 to 0.5 s.

5. Control circuit according to claim 3 or 4, characterised in that the measuring circuit comprises a second delay relay (27) through which, at the end of an additional time interval of 1 to 3 s. from the return into circuit of the driving motor (28), the resistances (23, 24, 25) are again connected to restore the initial sensitivity.

6. Control circuit according to claim 1 or 2, characterised in that the measuring circuit comprises a feedback amplifier provided with a field effect transistor of which the drain/source resistance reduces continuously as the damping created by the detector increases and which thus equalises the output voltage of this amplifier, the choice of time constant in relation to the increase in damping being such that the threshold is only reached by the signal if a predetermined rate of alteration of the damping is exceeded.

7. Control circuit according to claim 6, characterised in that the time constant of the measuring circuit containing the field effect transistor (38) determined by a first RC group (39, 40) is chosen so as to follow the increases in damping as long as they are less than 10% per second.

8. Control circuit according to one of claims 6 and 7, characterised in that the measuring circuit containing the field effect transistor (38) has on the base of the transistor a second RC group (36, 37) giving the desensitization of the amplifier (35) a time constant which allows erasure of reductions in damping up to 50% per second and preferably up to 100% per second.

9. Control circuit according to claim 1 or 2, characterised in that the measuring circuit comprises an oscillator (45) having a frequency variable as a function of alteration of the parallel leak resistance of the detector (4), a counter for measuring frequency (46) and a measuring circuit (47) driving a relay (32) disconnecting feed of current to the driving motor (28).

10. Control circuit according to claim 9, characterised in that the variable frequency oscillator (45) comprises a transistor (50) and a hysteresis voltage comparator (51).

11. Control circuit according to claim 9 or 10, characterised in that the measuring circuit (47) comprises a register (53), a subtractor (54) and a control stage (55), the result of the subtraction by the subtractor (54) serving as the magnitude of the variation of parallel leak resistance of the capacitative detector.

12. Control circuit according to anyone of claims 1 to 11, characterised in that it comprises secondary commutation elements (resistance 71, 72) controlled by commutation lines arranged on the pane (60) so as to cooperate with a sliding contact placed in the frame of the window to increase by degrees the gain of the amplifier as a function of the position of the window in the final phase of closure of the window, and a contact (65) arranged on said pane to cooperate with said sliding contact to cut supply of current to the motor when the window is closed.

## Patentansprüche

1. Elektronische Sicherheits-Steuerschaltung für den Antriebsmotor eines Schiebefensters, insbesondere eines Autofensters, dessen Glasscheibe entlang ihrer freien Kante einen elektrischen Leiter trägt, der den kapazitiven Fühler eines einen Oszillator umfassenden Detektorkreises innerhalb der Steuerschaltung bildet, wobei diese Einrichtungen einem die Stromzufuhr zu dem Antriebsmotor unterbrechenden Verstärker ein Signal liefern, das zu der durch die Annäherung eines Körperteils bis in die unmittelbare Nähe des Fühlers hervorgerufenen Bedämpfungsänderung proportional ist, dadurch gekennzeichnet, dass der Detektorkreis eine Auswerteschaltung umfasst, die die Grösse der Änderung pro Zeiteinheit des parallelen Verlustwiderstandes des kapazitiven Fühlers feststellt und die Nutzsignale von den Störsignalen trennt, deren Änderungsgeschwindigkeit kleiner als 10% pro Sekunde und vorzugsweise kleiner als 5% pro Sekunde ist, um diese letzteren unschädlich zu machen.

2. Steuerschaltung nach Anspruch 1, dadurch gekennzeichnet, dass der Oszillator des Detektorkreises mit einer Frequenz von 250 kHz arbeitet.

3. Steuerschaltung nach Anspruch 1 oder 2 mit einem die Schaltschwelle bestimmenden Spannungs-Komparator, dadurch gekennzeichnet, dass die Auswerteschaltung eine Kette von Widerständen (23, 24, 25), die durch einen Umschalter (18) der Reihe nach in den Schaltkreis eingeschaltet bzw. aus diesem herausgenommen werden, wobei sie die Empfindlichkeit stufenweise ändern, sowie ein Zeitrelais (17) umfasst, das nach Ablauf eines gegebenen Zeitintervalls nach dem Umschaltvorgang den Zustand des Ausgangs des Komparators (16) prüft und nach und nach die aufeinanderfolgenden Widerstände herausnimmt, solange dieser Zustand sich nicht von neuem ändert.

4. Steuerschaltung nach Anspruch 3, dadurch gekennzeichnet, dass das Zeitrelais (17) so ausgelegt ist, dass die aufeinanderfolgenden Änderungen der Empfindlichkeit bei abnehmendem Signal in Zeitintervallen von 0,1 bis 0,5 s erfolgen.

5. Steuerschaltung nach einem der Ansprüche 3 und 4, dadurch gekennzeichnet, dass die Auswerteschaltung ein zweites Zeitrelais (27) umfasst, durch das nach Ablauf eines zusätzlichen Zeitintervalls von 1 bis 3 s nach erfolgtem Wiedereinschalten des Antriebsmotors (28) die Widerstände (23, 24, 25) zur Wiederherstellung der Ausgangsempfindlichkeit wieder zugeschaltet werden.

6. Steuerschaltung nach Anspruch 1 oder 2, dadurch gekennzeichnet, dass die Auswerteschaltung einen gegengekoppelten Verstärker mit einem Feldeffekttransistor umfasst, dessen Drain-Source-Widerstand sich mit zunehmender Bedämpfung des Fühlers kontinuierlich verringert, und der so die Ausgangsspannung dieses Verstärkers ausgleicht, wobei die Zeitkonstante bei Bedämpfungszunahme so gewählt wird, dass die Schaltschwelle durch das Signal nur bei Überschreiten einer vorgegebenen Geschwindigkeit der Bedämpfungsänderung erreicht wird.

7. Steuerschaltung nach Anspruch 6, dadurch gekennzeichnet, dass die durch eine erste RC-Gruppe (39, 40) gebildete Zeitkonstante der den Feldeffekttransistor (38) umfassenden Auswerteschaltung so gewählt wird, dass die Bedämpfungszunahme ausgeglichen wird, solange die Änderungsgeschwindigkeit kleiner als 10% pro Sekunde ist.

8. Steuerschaltung nach einem der Ansprüche 6 und 7, dadurch gekennzeichnet, dass die den Feldeffekttransistor (38) umfassende Auswerteschaltung an der Basis dieses Transistors eine zweite RC-Gruppe (36, 37) für die Empfindlichkeitserniedrigung des Verstärkers (35) umfasst, deren Zeitkonstante so gewählt ist, dass Verringerungen der Bedämpfung bei einer Änderungsgeschwindigkeit von bis zu 50% pro Sekunde, und vorzugsweise von bis zu 100% pro Sekunde, ausgeglichen werden.

9. Steuerschaltung nach Anspruch 1 oder 2, dadurch gekennzeichnet, dass die Auswerteschaltung einen Oszillator (45) mit in Abhängigkeit von der Änderung des parallelen Verlustwiderstandes des Fühlers (4) veränderlicher Frequenz, einen Zähler (46) zur Messung der Frequenz, sowie eine Auswerteschaltung (47) umfasst, die das die Stromzuführung zu dem Antriebsmotor (28) unterbrechende Relais (32) ansteuert.

10. Steuerschaltung nach Anspruch 9, dadurch gekennzeichnet, dass der Oszillator mit veränderlicher Frequenz (45) einen Transistor (50) und einen Spannungskomparator (51) mit Schalthysterese umfasst.

11. Steuerschaltung nach Anspruch 9 und 10, dadurch gekennzeichnet, dass die Auswerteschaltung (47) ein Speicherregister (53), eine Substraktionsstufe (54) und eine Schaltstufe (55) umfasst, wobei das in der Substraktionsstufe (54) gebildete Ergebnis der Substraktion als Mass für die Änderung des parallelen Verlustwiderstandes des kapazitiven Fühlers dient.

12. Steuerschaltung nach einem der Ansprüche 1 bis 11, dadurch gekennzeichnet, dass sie zusätzliche Schaltglieder (Widerstände 71, 72), die von auf der Glasscheibe (60) angeordneten, mit einem in dem Fensterrahmen angeordneten Schleifkontakt zusammenwirkenden Schaltlinien betätigt werden, um in Abhängigkeit von der Position der Fensterscheibe in der Endphase der Schliessbewegung der Fensterscheibe die Empfindlichkeit des Verstärkers stufenweise zu erhöhen, sowie einen auf der Glasscheibe angeordneten Kontakt (65) umfasst, der mit dem genannten Schleifkontakt zusammenwirkt, um die Stromzuführung zu dem Antriebsmotor zu unterbrechen, wenn die Glasscheibe geschlossen ist.

*Fig: 2*

*Fig: 1*

*Fig: 3*

Rp/kΩ

1400

1200

1000

800

600

400

200

0

A

B

C

D

E

E

4 3 2 1

40    35    30    25    20    15    10    5    0  [cm]

OUVERTE    ⟵ POSITION ⟶    FERMEE

9

Fig. 4

Fig. 5

*Fig. 6*

*Fig. 7*

*Fig. 8*

*Fig. 9*

**Fig. 10**